# FASCICULE DE BREVET EUROPEEN

(11) **EP 1 579 471 B1**
(45) Date de publication et mention de la délivrance du brevet: **12.10.2011**
(21) Numéro de dépôt: 03755581.0
(22) Date de dépôt: 08.07.2003
(51) Int. Cl.: H01J 37/34

(54) **CATHODE POUR PULVERISATION SOUS VIDE**
VAKUUM-SPUTTER-KATHODE
VACUUM SPUTTERING CATHODE

(30) Priorité: 10.07.2002 FR 0208869
(43) Date de publication de la demande: 28.09.2005
(73) Titulaire: H.E.F., 42160 Andrezieux-Boutheon (FR)
(72) Inventeur: AULAGNER, Michel, F-43330 St Ferreol d'Auroure (FR); LABALME, Lionel, F-42170 St Just St Rambert (FR)
(74) Mandataire: Thivillier, Patrick
(86) Numéro de dépôt international: PCT/FR2003/002111
(87) Numéro de publication internationale: WO 2004/008479

(56) Documents cités:
- CH-A- 672 319
- DE-U- 29 512 094
- US-A- 5 071 535
- US-A- 5 269 894

## Description

L'invention se rattache au secteur technique de la pulvérisation cathodique de matériaux, notamment dans une installation de traitement sous vide, et plus particulièrement des cathodes destinées à la production de vapeur.

Généralement, selon l'état antérieur de la technique, une cathode à membrane se présente sous forme d'une embase présentant, dans son épaisseur, des cavités constituant des canaux pour la circulation d'un fluide de refroidissement Sur cette embase est fixée, généralement au moyen de vis, une membrane. En regard de cette embase support à membrane, est montée, d'une manière jointive, une cible pour la pulvérisation d'un matériau. Généralement, la membrane est réalisée au moyen d'un seul matériau.

Cet état de le technique peut être illustré par l'enseigement des documents CH 672319 et US 5071535.

Pour resoudre ce pb il a été conçu une methode conforme aux caracteristiques de la revendication 1

Avantageusement, la membrane est composée d'au moins deux matériaux superposés.

L'invention est exposée ci-après plus en détail à l'aide des figures des dessins annexés dans lesquels :
- la figure 1 est une vue en perspective, avant montage, des principaux éléments de la cathode, selon l'invention ;
- la figure 2 est une vue en perspective correspondant à la figure 1, après assemblage des différents éléments ;
- la figure 3 est une vue en coupe transversale considérée selon la ligne 3-3 de la figure 2 ;
- la figure 4 est une vue partielle, à très grande échelle, montrant la structure interne de la membrane en tant que telle ;

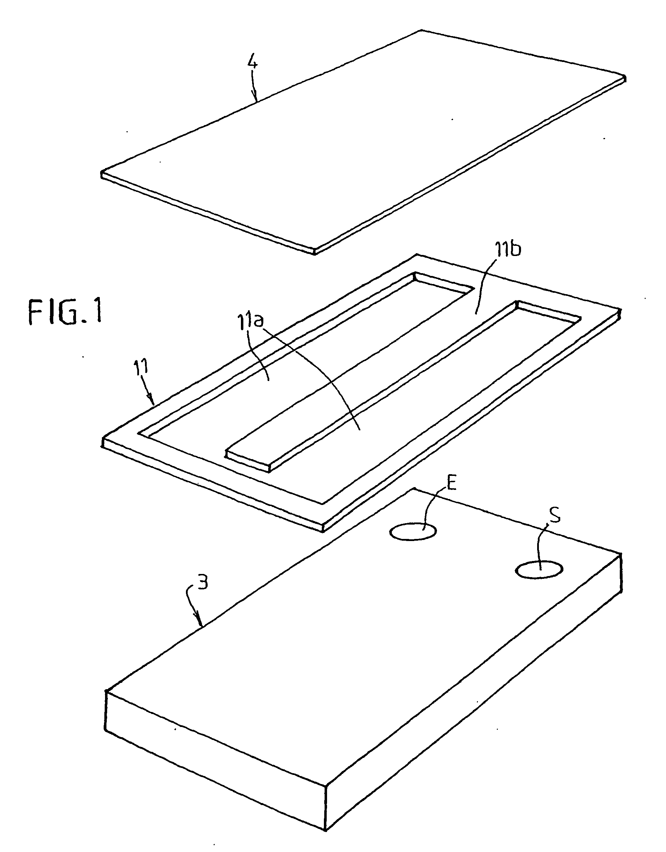

Comme le montre la figure 1, la cathode, selon l'invention, est composée d'une embase support (3) présentant tout type d'agencement pour la circulation d'un fluide de refroidissement avec une entrée (E) et une sortie (S). L'embase (3), par exemple de forme générale parallélépipédique, reçoit, en superposition, une plaque (11) convenablement découpée pour constituer un cadre délimitant au moins un espace vide (11a) pour la circulation du fluide de refroidissement.

L'un des côtés au moins du cadre (11) présente, dans le même plan, au moins un bras (11b) pour délimiter des canaux de circulation du fluide de refroidissement.

Ce cadre (11) reçoit, en superposition, une membrane (4). L'embase (3), le cadre (11) et la membrane (4) sont assemblés ensemble, au niveau de leur périphérie. Par exemple, cette liaison s'effectue au moyen d'une soudure traversante (ST).

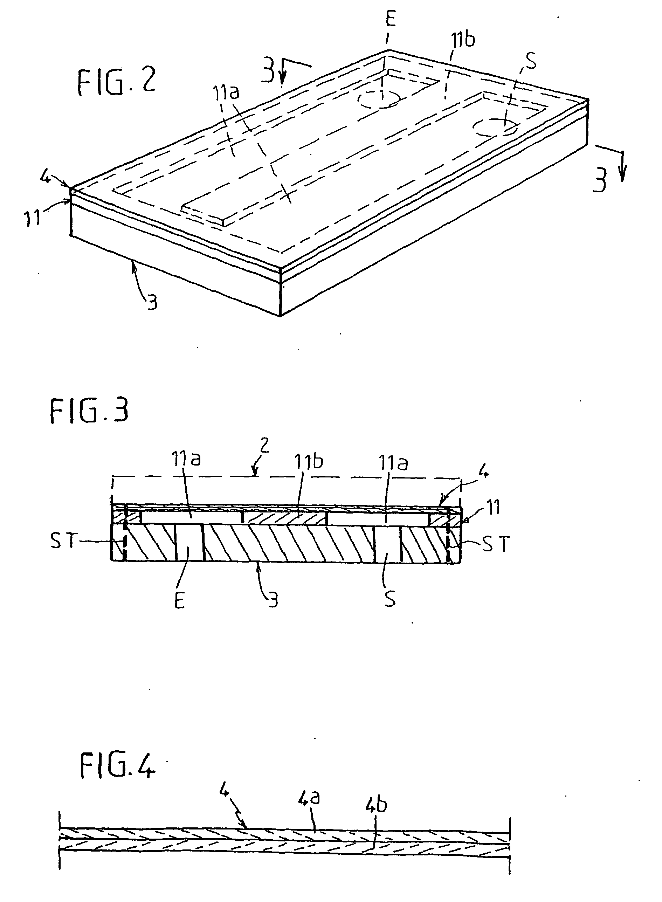

Selon une autre caractéristique, la membrane (4) est composée d'au moins deux couches (4a) et (4b) de matériaux différents. La couche (4b), disposée du côté du cadre (11) qui fait office de structure, est réalisée dans un matériau sélectionné pour accepter une déformation élastique. L'autre couche (4a) est réalisée dans un matériau sélectionné pour accepter une déformation plastique, afin d'épouser la surface d'une cible de pulvérisation (2) (tracé traits interrompus, figure 3).

Ainsi, l'invention trouve une application avantageuse dans le domaine de la pulvérisation cathodique sous vide au moyen d'une cible.

Les avantages ressortent bien de la description.

## Revendications

1. Cathode pour pulvérisation sous vide dont le support de cible (2) est constitué par un refroidisseur, **caractérisée en ce qu'**elle comprend une embase support (3) sur laquelle est superposé un cadre (11) qui présente, dans le même plan, au moins un bras (11b) pour délimiter des canaux de circulation (11a) d'un fluide de refroidissement.
ledit cadre (11) recevant en superposition une membrane (4), l'embase (3), le cadre (11) et la membrane (4) étant assemblés ensemble en périphérie.

2. Cathode selon la revendication 1, **caractérisée en ce que** la membrane (4) est composée d'au moins deux matériaux superposés (4a) et (4b).

## Claims

1. Vacuum sputtering cathode whereof the target holder (2) consists of a heat sink, **characterised in that** it comprises a support base (3) on which there is placed a frame (11) which has, in the same plane, at least one arm (11b) for delimiting channels (11a) through which a cooling fluid flows, said frame accommodating a superposed membrane (4), base (3), frame (11) and membrane (4) being assembled together around the periphery.

2. Cathode as claimed in claim 1, **characterised in that** membrane (4) comprises at least two superposed materials (4a) and (4b).

## Patentansprüche

1. Kathode für Vakuumzerstäubung, deren Target-Unterlage (2) aus einer Kühlvorrichtung besteht, **dadurch gekennzeichnet, dass** sie einen Unterlagensockel (3) umfasst, auf dem ein Rahmen (11) aufgesetzt ist, der auf der gleichen Ebene mindestens einen Arm (11b) aufweist, um Zirkulationskanäle (11a) eines Kühlmittels abzugrenzen, wobei auf den Rahmen (11) eine Membran (4) gesetzt wird und Sockel (3), Rahmen (11) und Membran (4) am Rand miteinander verbunden sind.

2. Kathode nach Anspruch 1, **dadurch gekennzeichnet, dass** die Membran (4) aus mindestens zwei übereinander liegenden Materialien (4a und 4b) besteht.
